# FASCICULE DE BREVET EUROPEEN

(11) **EP 1 846 957 B1**
(45) Date de publication et mention de la délivrance du brevet: **17.07.2013**
(21) Numéro de dépôt: 05817521.7
(22) Date de dépôt: 08.12.2005
(51) Int. Cl.: H01L 31/18

(54) **PROCEDE DE FABRICATION DE CELLULES PHOTOVOLTAIQUES**
VERFAHREN ZUR HERSTELLUNG VON FOTOVOLTAISCHEN ZELLEN
METHOD FOR THE PRODUCTION OF PHOTOVOLTAIC CELLS

(30) Priorité: 21.12.2004 FR 0453127
(43) Date de publication de la demande: 24.10.2007
(73) Titulaire: Solarforce, 38300 Bourgoin Jallieu (FR)
(72) Inventeur: BELOUET, Christian, F-92330 Sceaux (FR); REMY, Claude, F-69760 Limonest (FR)
(74) Mandataire: Lenne, Laurence
(86) Numéro de dépôt international: PCT/EP2005/056621
(87) Numéro de publication internationale: WO 2006/067051

(56) Documents cités:
- EP-A- 0 079 567
- DE-A1- 19 525 720
- FR-A- 2 363 199
- FR-A- 2 529 189
- FR-A- 2 561 139
- US-A- 4 383 130
- US-A- 6 090 199
- BELOUET C ET AL.: "Technical and economical aspects of the RAD silicon ribbon growth process" CONFERENCE RECORD OF THE NINETEENTH IEEE PHOTOVOLTAIC SPECIALISTS CONFERENCE, 4-8 MAY 1987, NEW ORLEANS, LA, USA, 1987, pages 372-377, XP008051287 New York, NY, USA
- MOUDDA-AZZEM T ET AL: "Reseaux de dislocations induits par le dopage au phosphore dans le silicium polycristallin (RAD)", JOURNAL OF CRYSTAL GROWTH, ELSEVIER, AMSTERDAM, NL, vol. 83, no. 1, 1 May 1987 (1987-05-01), pages 105-114, XP024451561, ISSN: 0022-0248, DOI: 10.1016/0022-0248(87)90510-0 [retrieved on 1987-05-01]
- BELOUET ET AL: "Growth of silicon ribbons by the RAD process", JOURNAL OF CRYSTAL GROWTH, ELSEVIER, AMSTERDAM, NL, vol. 82, no. 1-2, 1 March 1987 (1987-03-01), pages 110-116, XP024429852, ISSN: 0022-0248, DOI: 10.1016/0022-0248(87)90173-4 [retrieved on 1987-03-01]

## Description

La présente invention a pour objet un procédé de fabrication de cellules photovoltaïques sur des rubans ou des bandes d'un matériau semi-conducteur, notamment du silicium.

Pour la fabrication de cellules photovoltaïques à grande échelle, tout particulièrement pour panneaux solaires, une solution consiste à utiliser un ruban composite formé d'un ruban de carbone recouvert sur ses deux faces d'une couche de silicium polycristallin. Le ruban de carbone traverse en continu un bain de silicium fondu, de préférence verticalement. En sortant du bain, le ruban de carbone se couvre d'une couche de silicium relativement mince sur les deux faces du ruban. On obtient ainsi un ruban composite silicium/carbone/silicium. Ce procédé, appelé procédé "RST" (pour Ruban de silicium sur Substrat de carbone Temporaire), est décrit dans plusieurs brevets, par exemple FR 2 386 359, FR 2 550 965 ou FR 2 568 490. Il permet d'obtenir des couches de silicium d'épaisseur aussi petite que 50 µm. Cependant, ces couches minces sont fragiles et donc difficiles à manipuler. Pour cette raison, les couches ainsi fabriquées ont des épaisseurs généralement supérieures à 150 µm.

Les rubans composites sont découpés en plaquettes composites de petites tailles (à titre d'exemple, 12,5 cm x 12,5 cm). Ces plaquettes sont ensuite chauffées dans un gaz contenant de l'oxygène à une température voisine de 1000°C afin de brûler le ruban de carbone. L'opération, appelée "brûlage", est par exemple décrite dans le brevet FR 2.529.189. On obtient ainsi, à partir de chaque plaquette composite, deux plaquettes minces de silicium de mêmes dimensions que les plaquettes composites, c'est-à-dire de petites dimensions. Les plaquettes de silicium subissent ensuite divers traitements conduisant à la réalisation de cellules photovoltaïques, ces traitements étant différents selon le type de cellules que l'on veut fabriquer. De façon générale, après le brûlage on procède à une désoxydation des faces avant et arrière, à la formation de jonctions par diffusion d'un précurseur sur au moins l'une des faces, au dépôt d'une couche antireflet sur la face avant et aux dépôts des contacts électriques.

Ce procédé de fabrication de plaquettes est un procédé discontinu, bien adapté à la fabrication de plaquettes de petites dimensions relativement épaisses (d'épaisseurs supérieures à 150 µm), qui s'insère bien dans la technologie actuelle de fabrication des cellules photovoltaïques réalisées à partir de plaques de silicium cristallin.

**Du document** Moudda-Azzem T. et al « Réseaux de dislocations induits par le dopage au phosphore dans le silicium polycristallin (RAD) » Journal of Crystal Growth 83 (1987) 105-114**, est également connu un ruban inerte chimiquement sur lequel est formée une double couche de silicium, lesdites couches de silicium étant dopées puis séparées par brûlage du support.**

Cependant, afin de rendre économiquement attractive l'électricité photovoltaïque obtenue par la filière silicium cristallin, il est souhaitable de mettre en oeuvre des cellules photovoltaïques très minces (d'épaisseurs comprises entre 30 et 100 µm) et à haut rendement de conversion photovoltaïque.

Dans cette perspective, le procédé ci-dessus est confronté au problème critique de la manipulation de plaques minces, d'épaisseurs inférieures à 150 µm. En effet, les manipulations multiples de telles plaques de grandes dimensions, fragiles car minces et présentant des contraintes résiduelles importantes, à des cadences élevées (supérieures à 1000 unités à l'heure), sont une cause de dégradation importante du rendement de fabrication.

La présente invention propose un procédé de fabrication de cellules photovoltaïques selon la revendication 1 permettant de diminuer les coûts de fabrication, d'augmenter le rendement de fabrication des cellules et d'obtenir des cellules de grandes longueurs. Le procédé est particulièrement avantageux pour la réalisation de cellules de très faibles épaisseurs, comprises entre 30 et 100 µm, mais il s'applique également aux plus grandes épaisseurs.

De façon plus précise, l'invention concerne un procédé de fabrication de cellules photovoltaïques selon lequel au moins une couche de matériau semi-conducteur est déposée en continu sur un ruban de carbone pour former un ruban composite, ladite couche ayant une face libre opposée à sa face en contact avec le ruban de carbone. Selon le procédé, au moins un traitement est appliqué à la couche de matériau semi-conducteur, à partir de la face libre, en vue de réaliser des fonctions photovoltaïques desdites cellules, suivi par l'élimination du dépôt de matériau semi-conducteur sur les flancs du ruban composite, avant l'élimination du ruban de carbone de sorte à mettre à nu le chant de ruban de carbone, et l'élimination du ruban de carbone, par brûlage.

Selon un mode de mise en oeuvre, le traitement comprend la création d'une pluralité de zones de contact (formant les bases des cellules) par dépôt d'un matériau précurseur sur la face libre, laquelle constitue la face arrière desdites cellules, le matériau précurseur comportant des éléments dopants, par exemple bore ou phosphore, qui conservent le type de dopage, n ou p, dudit matériau semi-conducteur.

Selon un autre mode de mise en oeuvre, le traitement comprend la création d'une pluralité de zones de jonction (formant les émetteurs des cellules) par dépôt d'un matériau précurseur sur la face libre, laquelle constitue la face arrière desdites cellules, le matériau précurseur comportant des éléments dopants, par exemple bore ou phosphore, qui changent le type de dopage du matériau semi-conducteur. Le traitement peut comprendre la création d'une pluralité de zones isolant électriquement lesdites zones de contact (les bases) desdites zones de jonction (les émetteurs), par exemple par dépôt d'un matériau oxydant sur la face libre.

Selon un autre mode de mise en oeuvre, le traitement comprend la création d'une pluralité de zones de jonction par dépôt d'un matériau précurseur sur la face libre, laquelle constitue la face avant desdites cellules, ledit matériau précurseur comportant des éléments dopants, par exemple bore ou phosphore, qui changent le type de dopage du matériau semi-conducteur.

Selon un autre mode de mise en oeuvre, le traitement comprend le percement de trous, par laser par exemple, dans la couche de matériau semi-conducteur, sensiblement perpendiculairement à ladite face libre, les trous traversant la couche de matériau semi-conducteur.

Selon un autre mode de réalisation, le traitement comprend l'ablation du matériau semi-conducteur recouvrant les flancs du ruban composite, par exemple par ablation laser, par ablation laser assistée par jet d'eau ou par décapage par plasma.

Le ruban de carbone est éliminé par brûlage, après réalisation d'au moins l'un des traitements mentionnés précédemment. La diffusion de dopants à partir dudit matériau précurseur dans le matériau semi-conducteur peut être réalisée au cours du brûlage du ruban de carbone.

Tout ou partie des traitements énumérés peuvent être réalisés en continu. De façon alternative, le ruban composite peut être découpé pour former des bandes composites de grandes longueurs, le ou les traitements étant appliqués auxdites bandes composites (donc avant élimination du ruban de carbone). Les longueurs desdites bandes sont, par exemple, comprises entre 1,0 et 4,50 mètres.

Selon un mode de mise en oeuvre du procédé, des bandes de matériau semi-conducteur de grandes longueurs sont obtenues par élimination du carbone de bandes composites découpées dans le ruban composite et au moins une des opérations suivantes est effectuée sur lesdites bandes de matériau semi-conducteur : texturation de la face avant des cellules photovoltaïques, réalisation de zones de jonction, dépôt d'une couche antireflet sur la face avant des cellules, dépôt de contacts électriques sur les faces avant et arrière des cellules.

Le matériau semi-conducteur est de préférence du silicium. Le précurseur est par exemple à base d'oxyde chargé en bore (additionné parfois d'aluminium) si l'on désire augmenter le dopage de type p ou chargé en phosphore si l'on désire augmenter le dopage de type n. Le ruban composite est avantageusement fabriqué par le procédé RST, le ruban comprenant avantageusement deux couches de matériau semi-conducteur entourant le ruban de carbone, chacune des deux couches de matériau semi-conducteur ayant une face libre sur laquelle est appliqué le ou les traitements.

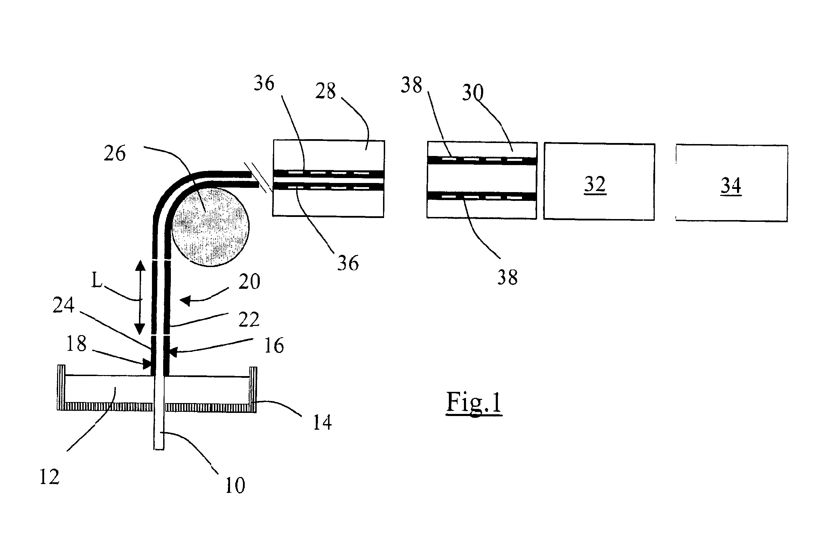

D'autres avantages et caractéristiques de l'invention apparaîtront au cours de la description qui va suivre de plusieurs modes de réalisation, donnés à titre d'exemples non limitatifs, en référence au dessin de la figure 1 (figure unique) qui représente schématiquement différents modes de mise en oeuvre de l'invention.

L'exemple de mise en oeuvre représenté sur la figure 1 fait appel au procédé RST d'obtention de plaques minces de silicium polycristallin, d'épaisseur comprise entre 250 et 50 µm. Selon ce procédé, un ruban de carbone 10, approximativement d'épaisseur 220 µm et de largeur 12,5 cm, défile en continu, verticalement, dans un bain de silicium fondu 12 contenu dans un bâti de tirage 14. A la surface du bain, lorsque le ruban de carbone quitte le bain de silicium, deux couches 16 et 18 de silicium polycristallin se déposent en adhérant sur les deux faces du ruban de carbone 10. L'épaisseur des couches de silicium dépend notamment de la vitesse de défilement du ruban dans le bain, l'épaisseur étant d'autant plus faible que la vitesse est grande. A titre d'exemple, on peut obtenir des épaisseurs inférieures ou égales à 80 µm pour une vitesse de défilement voisine de 10 cm/minute. A la sortie du bain, on obtient un ruban composite 20 formé de deux couches minces 16 et 18 de silicium entourant le ruban de carbone. La couche 16 possède une face en contact avec le ruban de carbone 10 et une face opposée 22, dite face libre. De même, la couche 18 possède une face en contact avec le ruban de carbone 10 et une face opposée 24, dite face libre.

Selon la présente invention, un ou plusieurs traitements sont appliqués directement sur le ruban composite, avant séparation des couches de silicium du ruban de carbone, à partir de la face libre 22 ou 24 de chacune des deux couches de silicium. A la sortie du bâti de tirage 14, le ruban composite 20 (silicium/carbone/silicium) n'est donc plus découpé en plaquettes élémentaires, qui sont ensuite traitées individuellement pour réaliser les cellules photovoltaïques. Au contraire, selon l'invention, on pratique le maximum d'opérations qui conduisent à la cellule photovoltaïque finale sur le ruban composite 20 ou sur des bandes composites de grandes longueurs, en profitant du support que constitue le ruban de carbone.

II y a deux variantes possibles de mise en oeuvre de l'invention à la sortie du bâti de tirage.

Selon une première variante, les traitements sont effectués sur le ruban composite en continu, en mettant en ligne le maximum d'opérations jusqu'à la phase d'élimination du ruban de carbone. A la sortie du bâti de tirage 14, le ruban composite 20 est dévié de 90° au moyen d'un rouleau 26 pour passer d'une position verticale à une position horizontale. Cette variante n'est possible que si le ruban composite 20 est suffisamment flexible pour être dévié sans subir de dommages, et donc si l'épaisseur des couches de silicium est faible, par exemple inférieure ou égale à 100 µm.

Cette variante implique cependant, avant de courber le ruban, d'éliminer le dépôt de silicium sur les flancs du ruban composite selon la revendication 1 afin de réduire le rayon de courbure du ruban à des valeurs acceptables en pratique, par exemple inférieures à environ 0,5 m. Ce traitement peut être fait par ablation laser, par ablation laser assistée par jet d'eau, par plasma ou toute autre solution appropriée. Dans tous les cas, il met à nu le chant du ruban de carbone. Cette opération est également réalisée dans d'autres variantes de mise en oeuvre, mais elle peut être effectuée plus tard dans le processus de fabrication, cependant au plus tard avant l'élimination du ruban de carbone. Le rayon de courbure du ruban peut encore être diminué en appliquant un film polymère adhérent et amovible sur la face extérieure du ruban (en extension) sur toute la longueur courbée et notamment au voisinage du chant de découpe. Après déviation, le ruban composite est envoyé vers une chambre 28 pour y subir différents traitements en continu.

Selon une deuxième variante de mise en oeuvre, le ruban composite est découpé en bandes 36 de grandes longueurs L, typiquement de 1,0 à 4,5 m. Cette variante convient bien pour des épaisseurs plus grandes de silicium, typiquement au-dessus de 100 à 150 µm, notamment pour des épaisseurs voisines de 200 µm. Cette variante de mise en oeuvre est aussi choisie lorsque les vitesses de traitement optimales d'un poste de traitement à l'autre ne sont pas compatibles entre elles ou impliquent une perte de productivité globale du procédé. Les bandes composites 36, éventuellement issues de plusieurs bâtis de tirage 14 fonctionnant en parallèle, sont ensuite placées dans la chambre 28 pour y être traitées.

Dans cette chambre 28, les couches de silicium du ruban composite 20 ou des bandes composites 36 de grandes longueurs L font l'objet d'un ou de plusieurs traitements classiques à partir de leurs faces libres 22 et 24, en vue de réaliser des fonctions photovoltaïques des cellules, avant l'élimination du ruban de carbone. Les faces libres constitueront les faces avant ou arrière des cellules selon le ou les traitements appliqués. Ces traitements ont pour but de créer des zones de jonctions et/ou des zones de contacts et/ou des zones destinées à isoler électriquement les précédentes. Les zones de jonction et de contact sont par exemple réalisées à partir d'un matériau précurseur chargé en éléments dopants déposé à des endroits déterminés des faces libres. Des trous peuvent aussi être percés par laser dans les couches de silicium, traversant complètement les couches, afin d'assurer des liaisons électriques entre des zones de jonction en face avant et en face arrière des cellules photovoltaïques, lorsque les cellules à réaliser sont du type MWT (Metallisation Wrap Through) et/ou pour améliorer l'étape suivante d'élimination du ruban de carbone. Les trous sont réalisés avant la création des zones de jonction.

On remarque que le ruban de carbone agit, pendant ces traitements, comme un support mais aussi comme une barrière de diffusion.

L'opération suivante consiste à, simultanément, éliminer le ruban de carbone et diffuser le ou les dopants du ou des précurseurs dans le matériau semi-conducteur. Pour cela, le ruban composite 20 pénètre en continu dans un four ouvert 30. De façon alternative, il peut être découpé à la sortie de la chambre 28 en bandes composites de grandes longueurs, par exemple de 1,5 à 4,5 m. Ces bandes, ainsi qu'éventuellement les bandes 36 issues de la chambre 28, sont regroupées dans le four 30 pour y subir un traitement de masse, ce qui réduit les coûts. L'élimination du ruban de carbone est effectuée à haute température (voisine de 1000°C) par oxydation, à partir des flancs du ruban de carbone (débarrassés du dépôt de silicium), et éventuellement à partir des trous perçants (déjà présents pour les structures MWT), par translation continue dans le four 30. Dans ce procédé d'élimination du ruban de carbone, les couches de silicium sont séparées pour donner des bandes de silicium 38 autosupportées. Le profil de température dans le four de brûlage 30, sa longueur et la vitesse de translation du ruban composite 20 ou des bandes composites 36 sont optimisés pour assurer une diffusion optimale des dopants dans les zones de jonctions et de contacts métalliques déposés dans la chambre 28 et pour obtenir une cinétique de brûlage du ruban de carbone satisfaisante. Dans tous les cas, la largeur du ruban, la composition en dopant des films précurseurs de diffusion, la durée et la température du brûlage, sont des paramètres interdépendants qui sont optimisés dans un contexte global prenant en compte la productivité du procédé et le rendement de conversion des cellules photovoltaïques.

Les bandes de silicium 38 issues du brûlage sont des éléments continus (procédé continu), par exemple d'une centaine de mètres de long, ou des bandes de silicium de plusieurs mètres. Ces bandes sont flexibles et susceptibles, pour les bandes minces, d'être enroulées / déroulées pour toutes les opérations ultérieures qui complètent la fabrication des cellules photovoltaïques. Ces opérations, représentées symboliquement par un rectangle 32, sont classiques et bien connues par l'homme du métier. Elles sont effectuées de façon classique sur des plaquettes de petites dimensions alors que selon l'invention elles sont effectuées sur des bandes de grandes longueurs. Elles comportent la désoxydation de la face de la bande de silicium opposée à la face libre (par exemple par plasma à la pression atmosphérique), la réalisation sur cette face de jonctions n⁺ /p ou p⁺/n par diffusion (cas de la cellule photovoltaïque classique et des cellules MWT) et / ou le dépôt d'une couche de passivation SiNx, les dépôts des contacts électriques (par exemple par des techniques de sérigraphie ou de jet d'encres) et les traitements thermiques finals.

Les bandes de silicium de grandes longueurs sont ensuite découpées en cellules photovoltaïques élémentaires aux dimensions souhaitées (opération représentée par le rectangle 34). Elles peuvent être de grandes longueurs, au maximum les longueurs des bandes de silicium. Ce découpage ne s'effectue qu'au moment de la mise en module.

Deux exemples de traitements successifs vont maintenant être décrits en supposant que le ruban composite silicium/carbone/silicium 20 issu du bâti de tirage 14 a été découpé en bandes composites de grandes longueurs L, par exemple voisines de 2 m.

### Exemple 1 :

Cet exemple concerne une structure classique de cellule photovoltaïque au silicium comprenant les éléments successifs suivants, en partant de la face avant vers la face arrière de la cellule : contact électrique, couche antireflet, zone de jonction ou émetteur (n+/p si silicium dopé p ou p+/n si silicium dopé n), couche de silicium, zone de contact arrière ou base (qui est en fait une jonction p+/p si le silicium est dopé p ou n+/n si le silicium est dopé n) et contact électrique. De façon générale pour ce type de cellules, les zones de contact définies ci-dessus sont toujours placées en face arrière (base) et de même type de dopage, n ou p, que le silicium, et le type de dopage des zones de jonction est opposé au type de dopage du silicium. L'épaisseur d'une telle structure est typiquement de 200 µm.

Sur les deux faces libres des bandes composites, qui formeront les faces arrière des cellules photovoltaïques, on applique un matériau précurseur pour former une pluralité de zones de contact. Le précurseur est, par exemple, à base d'oxyde chargé en bore (additionné parfois d'aluminium) si l'on désire augmenter le dopage de type p ou chargé en phosphore si l'on désire augmenter le dopage de type n. Le silicium recouvrant les flancs des bandes composites est enlevé par laser, avant ou après le dépôt du matériau précurseur. Afin de faciliter l'étape suivante de brûlage du carbone, des trous peuvent éventuellement être percés dans les couches de silicium.

Les bandes composites passent ensuite dans un four pour, d'une part, éliminer le ruban de carbone par brûlage, obtenant ainsi des bandes de silicium de grandes longueurs, et d'autre part, pour diffuser le dopant du précurseur dans le silicium afin de créer les contacts p+/p ou n+/n.

Sur ces grandes bandes de silicium, on crée ensuite, par diffusion en phase gazeuse ou à partir d'un précurseur chargé en phosphore ou en bore, une pluralité de jonctions n+/p ou p+/n sur les faces avant des cellules préalablement désoxydées (par traitement plasma à la pression atmosphérique par exemple). On désoxyde les faces avant et arrière, on dépose une couche antireflet sur la face avant, on dépose les contacts électriques sur les faces avant et arrière (par exemple par sérigraphie ou jet d'encre), on recuit les contacts, on découpe les bandes aux dimensions souhaitées (par découpe laser ou par découpe partielle suivie d'un clivage) et on encapsule les cellules.

### Exemple 2 :

Cet exemple concerne une structure de cellule photovoltaïque du type MWT qui est bien adaptée aux faibles épaisseurs de silicium, par exemple inférieures à 200 µm. Cette structure comporte en face avant, outre une couche antireflet, des lignes conductrices étroites, déposées sur des zones de jonctions n+/p (émetteur de la cellule) si le silicium est de type p et p+/n si le silicium est de type n. Sur la face arrière des cellules, des zones de jonctions, identiques aux jonctions de la face avant, alternent avec des zones de contacts p+/p (analogues à celles de la base de la cellule classique) si le silicium est de type p et n+/n si le silicium est de type n. Les zones de jonctions et les zones de contacts, appelées émetteur et base, sont séparées par des zones ou «tranchées » électriquement isolantes (zones oxydées). Des trous perçants, dont les parois sont dopées comme les zones de jonction de la face avant des cellules, assurent la liaison électrique entre les jonctions de la face avant et les zones de jonctions de la face arrière. C'est sur ces dernières que sont pris les contacts électriques de l'émetteur « ramené.» en face arrière grâce aux trous perçants.

Sur les faces libres des bandes composites, qui seront les faces arrière des cellules, on dépose un matériau précurseur à base d'oxyde de bore de façon à créer les zones de contact p+/p de la base (avec du silicium de type p), éventuellement sur toute la face libre. Puis, par ablation laser ou toute autre technique, on décape la surface pour ne laisser le précurseur qu'aux endroits où on veut créer les zones de contact de la base. On dépose ensuite un film d'oxyde SiOx, par exemple sur toute la surface libre y compris sur la zone précédemment décapée, A l'intérieur de cette dernière, on réalisera ultérieurement les zones de jonction n+/p (reprise de l'émetteur) et les zones isolantes. Pour cela, par une seconde attaque, par exemple par ablation laser ou toute autre technique, on élimine la couche de SiOx uniquement sur la fraction de la surface libre destinée à recevoir les zones de jonctions n+/p (reprise de l'émetteur). On perce ensuite des trous dans les couches de silicium à l'intérieur de ces zones de jonction n+/p. Les zones n+/p et les parois des trous sont ensuite recouverts d'un matériau précurseur à base d'oxyde de phosphore (n+) déposé par exemple au moyen d'un aérosol. A ce stade, on a réalisé les zones de contact p+/p (recouvertes de SiOx), les zones de jonctions n+/p et les zones recouvertes par une couche de SiOx isolant les zones de contact et les zones de jonction. Le mode de réalisation des zones de jonctions et de contacts de la base n'est pas exhaustif. Des techniques de dépôt des précurseurs par sérigraphie sont aussi applicables. Le silicium déposé sur les bords des bandes composites est éliminé.

Puis le ruban de carbone est brûlé dans un four, séparant les deux couches de silicium de chaque bande composite. L'élévation de température permet également de diffuser les dopants des précurseurs dans le silicium pour achever de créer les jonctions et les contacts. Si les précurseurs ont été déposés par sérigraphie, cette étape permet d'oxyder et de passiver les zones qui séparent physiquement les zones de jonctions et de contacts de la base sur les faces libres. Les étapes suivantes sont alors effectuées sur des bandes de silicium de grandes longueurs.

La face avant des cellules (face qui était en regard du carbone) est désoxydée et éventuellement texturée de façon à augmenter l'efficacité des cellules. Après réalisation des zones de jonction sur cette face, une couche antireflet est aussi déposée sur la face avant. Les contacts électriques sont ensuite réalisés sur la face avant (émetteur) et sur la face arrière (reprise d'émetteur et base alternés). Les bandes de silicium ainsi équipées sont enfin découpées aux dimensions souhaitées pour les cellules photovoltaïques et encapsulées.

Les avantages procurés par la présente invention sont nombreux. Tout d'abord, les avantages dus à la présence du ruban de carbone dans le ruban composite sont conservés :
- Le dépôt continu d'un film de silicium plan, dont l'épaisseur peut être ajustée entre 300 µm et 50 µm sur chaque face opposée du substrat de carbone,
- La flexibilité du ruban composite à la sortie du bâti de tirage lorsque l'épaisseur des films de silicium est faible,
- La protection de la face des films de silicium au contact du carbone jusqu'à la phase de séparation de ces films du ruban de carbone,
- La possibilité de texturer facilement et en continu la surface des films au contact du carbone.

De plus, l'invention procure une réduction du coût de fabrication des cellules photovoltaïques minces ou épaisses par la mise en oeuvre d'un procédé de fabrication continu, ou quasi-continu avec des bandes de grandes longueurs, automatisable par opposition au procédé classique dont les diverses opérations sont réalisées sur des plaquettes de petites dimensions qui doivent être manipulées de nombreuses fois. Le rendement de fabrication des cellules photovoltaïques très minces est plus élevé que par le procédé classique, notamment du fait de la présence du ruban de carbone qui sert de support pour les traitements effectués avant l'opération de brûlage, ce support diminuant les risques de casse.

On peut également obtenir des cellules photovoltaïques de grandes longueurs, adaptées à la taille du module photovoltaïque, flexibles et à contacts coplanaires en face arrière. Ces cellules minces peuvent éventuellement être courbées. Le rendement de conversion photovoltaïque des cellules est élevé, comparé à celui des cellules classiques, grâce à la faible épaisseur des couches de silicium et à la possibilité de fabriquer des cellules de type IBC (Interdigitated Back Contact) avec des contacts "inter digités" ou entrelacés reportés en face arrière (la face avant des cellules n'ayant plus de contacts électriques, toute la surface avant est utilisée pour recevoir la lumière incidente).

Les modes de réalisation décrits utilisent des rubans composites obtenus par le procédé RST. Il est évident pour l'homme du métier que, d'une part, on peut ne déposer qu'une seule couche de silicium sur le ruban de carbone et, d'autre part, d'autres procédés peuvent éventuellement être utilisés comme le dépôt en phase vapeur permettant d'obtenir une couche mince (éventuellement continue) de silicium de grande largeur (par exemple 30 cm) déposée sur un substrat, tel qu'un ruban de carbone, facilement éliminable. De même, les exemples donnés concernent des couches minces de silicium. Le tirage horizontal sur un substrat de carbone à partir d'un bain fondu est un autre exemple de procédé de dépôt d'une couche de silicium, relativement épaisse (200 µm ou plus), sur une seule face.

## Revendications

1. Procédé de fabrication de cellules photovoltaïques comprenant les étapes suivantes :
- fabriquer un ruban composite (20) en déposant en continu deux couches (16,18) de matériau semi-conducteur entourant un ruban de carbone (10), le ruban de carbone traversant un bain de matériau semi-conducteur fondu, chacune des deux couches de matériau semi-conducteur ayant respectivement une face libre (22, 24) opposée à sa face en contact avec le ruban de carbone,
- appliquer au moins un traitement (28) à partir de la face libre (22, 24) d'au moins une desdites couches de matériau semi-conducteur, en vue de réaliser des fonctions photovoltaïques desdites cellules sur ladite couche, avant l'élimination du ruban de carbone (10),
- éliminer le dépôt de matériau semi-conducteur sur les flancs du ruban composite, avant l'élimination du ruban de carbone, de sorte à mettre à nu le chant du ruban de carbone, et
- éliminer par brûlage le ruban de carbone (10).

2. Procédé selon la revendication 1, **caractérisé en ce que** ledit traitement comprend la création d'une pluralité de zones de contact par dépôt d'un matériau précurseur sur ladite face libre (22, 24), laquelle constitue la face arrière desdites cellules, ledit matériau précurseur comportant des éléments dopants qui conservent le type de dopage, n ou p, dudit matériau semi-conducteur.

3. Procédé selon l'une des revendications précédentes, **caractérisé en ce que** ledit traitement comprend la création d'une pluralité de zones de jonction par dépôt d'un matériau précurseur sur ladite face libre (22, 24), laquelle constitue la face arrière desdites cellules, ledit matériau précurseur comportant des éléments dopants qui changent le type de dopage du matériau semi-conducteur.

4. Procédé selon les revendications 2 et 3, **caractérisé en ce que** ledit traitement comprend la création d'une pluralité de zones isolant électriquement lesdites zones de contact desdites zones de jonction.

5. Procédé selon la revendication 4, **caractérisé en ce que** lesdites zones isolantes sont créées par dépôt d'un matériau oxydant sur ladite face libre (22, 24).

6. Procédé selon la revendication 1, **caractérisé en ce que** ledit traitement comprend la création d'une pluralité de zones de jonction par dépôt d'un matériau précurseur sur ladite face libre (22, 24), laquelle constitue la face avant desdites cellules, ledit matériau précurseur comportant des éléments dopants qui changent le type de dopage du matériau semi-conducteur.

7. Procédé selon l'une des revendications précédentes, **caractérisé en ce que** ledit traitement comprend le percement de trous dans ladite couche de matériau semi-conducteur, sensiblement perpendiculairement à ladite face libre (22, 24), lesdits trous traversant ladite couche (16, 18) de matériau semi-conducteur.

8. Procédé selon la revendication 7, **caractérisé en ce que** ledit percement est effectué par laser.

9. Procédé selon l'une des revendications précédentes, **caractérisé en ce que** ledit traitement comprend l'ablation du matériau semi-conducteur recouvrant les flancs dudit ruban composite.

10. Procédé selon la revendication 9, **caractérisé en ce que** ledit matériau semi-conducteur est enlevé par l'un des procédés suivants : ablation laser, ablation laser assistée par jet d'eau, ablation par plasma.

11. Procédé selon la revendication 1 et l'une des revendications 2, 3 et 6, **caractérisé en ce que** la diffusion du ou des dopants du précurseur dans ledit matériau semi-conducteur est réalisée au cours du brûlage dudit ruban de carbone.

12. Procédé selon l'une des revendications précédentes, **caractérisé en ce que** ledit traitement est réalisé en continu.

13. Procédé selon l'une des revendications 1 à 11, **caractérisé en ce que** ledit ruban composite (20) est coupé pour former des bandes composites (36, 38) de grandes longueurs (L), ledit traitement étant appliqué auxdites bandes composites.

14. Procédé selon les revendications 11 et 13, **caractérisé en ce que** des bandes de matériau semi-conducteur de grandes longueurs sont obtenues par élimination du carbone desdites bandes composites (36, 38) et **en ce qu'**au moins une des opérations suivantes est effectuée sur lesdites bandes de matériau semi-conducteur : texturation de la face avant des cellules photovoltaïques, réalisation de zones de jonction, dépôt d'une couche antireflet sur la face avant des cellules, dépôt de contacts électriques sur les faces avant et arrière des cellules.

15. Procédé selon la revendication 13 ou 14, **caractérisé en ce que** les longueurs desdites bandes sont comprises entre 1,0 et 4,50 mètres.

16. Procédé selon l'une des revendications précédentes, **caractérisé en ce que** ledit matériau semi-conducteur est du silicium.

17. Procédé selon l'une des revendications 2, 3 et 6, **caractérisé en ce que** ledit matériau précurseur est à base d'oxyde chargé en bore si l'on désire augmenter le dopage de type p ou chargé en phosphore si l'on désire augmenter le dopage de type n.

18. Procédé selon les revendications 1 et 16, **caractérisé en ce que** ladite opération (32) est appliquée sur des bandes de silicium issues du brûlage.

19. Procédé selon l'une des revendications précédentes, **caractérisé en ce qu'**il comprend en outre l'étape consistant à appliquer au moins une opération (32) sur la face d'au moins une desdites couches de matériau semi-conducteur, opposée à la face libre (22, 24), après l'élimination du ruban de carbone (10), ladite opération complétant la fabrication des cellules photovoltaïques.

20. Procédé selon l'une des revendications précédentes, **caractérisé en ce que** l'élimination du ruban de carbone est effectuée à partir des flancs du ruban de carbone débarrassés du dépôt de matériau semi-conducteur.

## Patentansprüche

1. Verfahren zur Herstellung von photovoltaischen Zellen, umfassend die folgenden Schritte:
- Herstellen eines Verbundstreifens (20) unter ununterbrochener Ablegung von zwei Schichten (16, 18) aus Halbleitermaterial, das einen Kohlenstoffstreifen (10) umgibt, wobei der Kohlenstoffstreifen ein Bad aus geschmolzenem Halbleitermaterial durchquert, wobei jede der zwei Schichten aus Halbleitermaterial jeweils eine freie Seite (22, 24) aufweist, die ihrer Seite in Kontakt mit dem Kohlenstoffstreifen gegenüber liegt,
- Anwenden von mindestens einer Behandlung (28), ausgehend von der freien Seite (22, 24) von mindestens einer der Schichten aus Halbleitermaterial, um photovoltaische Funktionen der Zellen auf der Schicht durchzuführen, vor der Entfernung des Kohlenstoffstreifens (10),
- Beseitigen der Ablage von Halbleitermaterial auf den Kanten des Verbundstreifens vor der Beseitigung des Kohlenstoffstreifens, um die Schmalseite des Kohlenstoffstreifens freizulegen, und
- Beseitigen der Brennung des Kohlenstoffstreifens (10).

2. Verfahren nach Anspruch 1, **dadurch gekennzeichnet, dass** die Behandlung die Erzeugung einer Vielzahl von Kontaktbereichen durch die Ablage eines Vorläufermaterials auf der freien Seite (22, 24) umfasst, die die Hinterseite der Zellen darstellt, wobei das Vorläufermaterial Dotierungselemente umfasst, die die Dotierungsart, n oder p, des Halbleitermaterials beibehalten.

3. Verfahren nach einem der vorhergehenden Ansprüche, **dadurch gekennzeichnet, dass** die Behandlung die Erzeugung einer Vielzahl von Verbindungsbereichen durch die Ablage eines Vorläufermaterials auf der freien Seite (22, 24) umfasst, die die Hinterseite der Zellen darstellt, wobei das Vorläufermaterial Dotierungselemente umfasst, die die Dotierungsart des Halbleitermaterials ändern.

4. Verfahren nach Anspruch 2 und 3, **dadurch gekennzeichnet, dass** die Behandlung die Erzeugung einer Vielzahl von Bereichen umfasst, die die Kontaktbereiche der Verbindungsbereiche elektrisch isolieren.

5. Verfahren nach Anspruch 4, **dadurch gekennzeichnet, dass** die isolierenden Bereiche durch die Ablage eines oxydierenden Materials auf der freien Seite (22, 24) erzeugt werden.

6. Verfahren nach Anspruch 1, **dadurch gekennzeichnet, dass** die Behandlung die Erzeugung einer Vielzahl von Verbindungsbereichen durch die Ablage eines Vorläufermaterials auf der freien Seite (22, 24) umfasst, die die Vorderseite der Zellen darstellt, wobei das Vorläufermaterial Dotierungselemente umfasst, die die Dotierungsart des Halbleitermaterials ändern.

7. Verfahren nach einem der vorhergehenden Ansprüche, **dadurch gekennzeichnet, dass** die Behandlung den Durchstich von Löchern in die Schicht aus Halbleitermaterial umfasst, im Wesentlichen senkrecht zu der freien Seite (22, 24), wobei die Löcher die Schicht (16, 18) aus Halbleitermaterial durchqueren.

8. Verfahren nach Anspruch 7, **dadurch gekennzeichnet, dass** der Durchstich durch Laser erfolgt.

9. Verfahren nach einem der vorhergehenden Ansprüche, **dadurch gekennzeichnet, dass** die Behandlung die Abtragung des Halbleitermaterials umfasst, das die Kanten des Verbundstreifens bedeckt.

10. Verfahren nach Anspruch 9, **dadurch gekennzeichnet, dass** das Halbleitermaterial durch eines der folgenden Verfahren entfernt wird: Laserabtragung, Laserabtragung, unterstützt durch Wasserstrahl, Abtragung durch Plasma.

11. Verfahren nach Anspruch 1 und einen der Ansprüche 2, 3 und 6, **dadurch gekennzeichnet, dass** die Diffusion des oder der Dotierung(en) des Vorläufers in dem Halbleitermaterial im Laufe des Brennens des Kohlenstoffstreifens durchgeführt wird.

12. Verfahren nach einem der vorhergehenden Ansprüche, **dadurch gekennzeichnet, dass** die Behandlung ununterbrochen durchgeführt wird.

13. Verfahren nach einem der Ansprüche 1 bis 11, **dadurch gekennzeichnet, dass** der Verbundstreifen (20) geschnitten ist, um Verbundbänder (36, 38) mit großen Längen (L) zu bilden, wobei die Behandlung auf die Verbundbänder angewendet wird.

14. Verfahren nach Anspruch 11 und 13, **dadurch gekennzeichnet, dass** Bänder aus Halbleitermaterial mit großen Längen durch die Beseitigung des Kohlenstoffs von den Verbundbändern (36, 38) erhalten werden, und dadurch, dass mindestens eine der folgenden Bearbeitungen auf den Bändern aus Halbleitermaterial durchgeführt wird: Texturierung der vorderen Seite der photovoltaischen Zellen, Durchführung von Verbindungsbereichen, Ablage einer Antireflexschicht auf der vorderen Seite der Zellen, Ablage von elektrischen Kontakten auf den vorderen und hinteren Seiten der Zellen.

15. Verfahren nach Anspruch 13 oder 14, **dadurch gekennzeichnet, dass** die Längen der Bänder zwischen 1,0 und 4,50 Meter liegen.

16. Verfahren nach einem der vorhergehenden Ansprüche, **dadurch gekennzeichnet, dass** das Halbleitermaterial Silizium ist.

17. Verfahren nach einem der Ansprüche 2, 3 und 6, **dadurch gekennzeichnet, dass** das Vorläufermaterial auf Oxid, geladen mit Bor, basiert, wenn gewünscht wird, die Dotierung vom Typ p zu erhöhen, oder geladen mit Phosphor, wenn gewünscht wird, die Dotierung vom Typ n zu erhöhen.

18. Verfahren nach Anspruch 1 und 16, **dadurch gekennzeichnet, dass** die Bearbeitung (32) auf Bänder aus Silizium aus der Brennung angewendet wird.

19. Verfahren nach einem der vorhergehenden Ansprüche, **dadurch gekennzeichnet, dass** es außerdem den Schritt umfasst, der darin besteht, mindestens eine Bearbeitung (32) auf die Seite mindestens einer der Schichten aus Halbleitermaterial anzubringen, die der freien Seite (22, 24) gegenüber liegt, nach der Beseitigung des Kohlenstoffstreifens (10),wobei die Bearbeitung die Herstellung der photovoltaischen Zellen beendet.

20. Verfahren nach einem der vorhergehenden Ansprüche, **dadurch gekennzeichnet, dass** die Beseitigung des Kohlenstoffstreifens ausgehend von den Kanten des Kohlenstoffstreifens erfolgt, von denen die Ablage aus Halbleitermaterial entfernt wurde.

## Claims

1. A method for manufacturing photovoltaic cells comprising the following steps:
- manufacturing a composite strip (20) by continuously depositing two semiconducting material layers (16, 18) surrounding a carbon strip (10), the carbon strip crossing a molten semiconducting material bath, each of the two semiconducting material layers respectively having a free face (22, 24) opposite to its face in contact with the carbon strip,
- applying at least one treatment (28) from the free face (22, 24) of at least one of said semiconducting material layers, with view to producing photovoltaic functions of said cells on said layer, before removing the carbon strip (10),
- removing the semiconducting material deposit on the flanks of the composite strip, before removing the carbon strip, so as to expose the edge of the carbon strip, and
- removing the carbon strip (10) by burning it.

2. The method according to claim 1, **characterized in that** said treatment comprises the generation of a plurality of contact areas by depositing a precursor material on said free face (22, 24) , which forms the rear face of said cells, said precursor material including dopant elements which retain the type of doping, either n or p, of said semiconducting material.

3. The method according to any of the preceding claims, **characterized in that** said treatment comprises the generation of a plurality of junction areas by depositing a precursor material on said free face (22, 24), which forms the rear face of said cells, said precursor material including the open elements which change the type of doping of the semiconducting material.

4. The method according to claims 2 and 3, **characterized in that** said treatment comprises the generation of a plurality of areas electrically insulating said contact areas of said junction areas.

5. The method according to claim 4, **characterized in that** said insulating areas are generated by depositing an oxidizing material on said free face (22, 24).

6. The method according to claim 1, **characterized in that** said treatment comprises the generation of a plurality of junction areas I depositing a precursor material on said free face (22, 24), which forms the front face of said cells, said precursor material including dopant elements which change the type of doping of the semiconducting material.

7. The method according to one of the preceding claims, **characterized in that** said treatment comprises the piercing of holes in said semiconducting material layer, substantially perpendicularly to said free face (22, 24), said holes crossing said semiconducting material layer (16, 18).

8. The method according to claim 7, **characterized in that** said piercing is achieved by a laser.

9. The method according to one of the preceding claims, **characterized in that** said treatment comprises the ablation of the semiconducting material covering the flanks of said composite strip.

10. The method according to claim 9, **characterized in that** said semiconducting material is removed by one of the following methods: laser ablation, laser ablation assisted by a water jet, plasma ablation.

11. The method according to claim 1 and one of claims 2, 3 and 6, **characterized in that** the distribution of the dopant(s) from the precursor into said semiconducting material is achieved during the burning of said carbon strip.

12. The method according to one of the preceding claims, **characterized in that** said treatment is carried out continuously.

13. The method according to one of claims 1 to 11, **characterized in that** said composite strip (20) is cut in order to form composite strips (36, 38) of great lengths (L), said treatment being applied to said composite strips.

14. The method according to claims 11 and 13, **characterized in that** semiconducting material strips of great lengths are obtained by removing the carbon of said composite strips open (36, 38) and **in that** at least one of the following operations is carried out on said semiconducting material strips: texturation of the front face of the photovoltaic cells, production of junction areas, depositing an anti-reflective layer on the front face of the cells, deposition of electric contacts on the front and rear faces of the cells.

15. The method according to claim 13 or 14, **characterized in that** the lengths of said strips are comprised between 1.0 and 4.50 meters.

16. The method according to one of the preceding claims, **characterized in that** said semiconducting material is silicon.

17. The method according to one of claims 2, 3 and 6, **characterized in that** said precursor material is based on an oxide loaded with boron if it is desired to increase the doping of type p or loaded with phosphorus if it is desired to increase the doping of type n.

18. The method according to claims 1 and 16, **characterized in that** said operation (32) is applied on silicon strips from the burning.

19. The method according to one of the preceding claims, **characterized in that** it further comprises the step consisting of applying at least one operation (32) on the face of at least one of said semiconducting material layers, opposite to the free face (22, 24), after removing the carbon strip (10), said operation completing the manufacturing of the photovoltaic cells.

20. The method according to one of the preceding claims, **characterized in that** removal of the carbon strip is carried out from the flanks of the carbon strip cleared of the semiconducting material deposit.
